# EUROPEAN PATENT APPLICATION

(11) **EP 1 191 382 A2**
(43) Date of publication of application: **27.03.2002**
(21) Application number: 01000451.3
(22) Date of filing: 12.09.2001
(51) Int. Cl.: G02B 26/08, B81B 3/00

(54) **Stacked micromirror structures**

(30) Priority: 20.09.2000 US 234086 P
(71) Applicant: Texas Instruments Inc., Dallas, Texas 75251 (US)
(72) Inventor: Orcutt, John W., Richardson, TX 75080 (US); Melendez, Jose L., Plano, TX 75025 (US)
(74) Representative: Holt, Michael

(57) **Abstract**

A packaged micromirror assembly is disclosed. The assembly includes a micromirror (70) formed of a lower element (60) having a central mounting portion (63) surrounded by an intermediate gimbal portion and a frame portion (61). A magnet standoff (68) is attached to the central mounting portion (63) and an upper mirror surface (65) is attached to the magnet standoff (68). The micromirror (70) may be packaged into a body with coil drivers. A magnetic field generated by the coil drivers applies a torque to the magnet standoff (68) causing it to rotate; because of silicon hinges in the lower element (60), the upper mirror (65) can rotate in two axes.

## Description

### TECHNICAL FIELD OF THE INVENTION

This invention relates to the field of optical communications, and is more specifically directed to micromirrors used in such communications.

### DESCRIPTION OF THE RELATED ART

Modern data communications technologies have greatly expanded the ability to communicate large amounts of data over many types of communications facilities. This explosion in communications capability not only permits the communications of large databases, but has also enabled the digital communications of audio and video content. This high bandwidth communication is now carried out over a variety of facilities, including telephone lines (fiber optic as well as twisted-pair), coaxial cable such as supported by cable television service providers, dedicated network cabling within an office or home location, satellite links, and wireless telephony.

Each of these conventional communications facilities involves certain limitations in their deployment. In the case of communications over the telephone network, highspeed data transmission, such as that provided by digital subscriber line (DSL) services, must be carried out at a specific frequency range to not interfere with voice traffic, and is currently limited in the distance that such high-frequency communications can travel. Of course, communications over "wired" networks, including the telephone network, cable network, or dedicated network, requires the running of the physical wires among the locations to be served. This physical installation and maintenance is costly, as well as limiting to the user of the communications network.

Wireless communication facilities of course overcome the limitation of physical wires and cabling, and provide great flexibility to the user. Conventional wireless technologies involve their own limitations, however. For example, in the case of wireless telephony, the frequencies at which communications may be carried out are regulated and controlled; furthermore, current wireless telephone communication of large data blocks, such as video, is prohibitively expensive, considering the per-unit-time charges for wireless services. Additionally, wireless telephone communications are subject to interference among the various users within the nearby area. Radio frequency data communication must also be carried out within specified frequencies, and is also vulnerable to interference from other transmissions. Satellite transmission is also currently expensive, particularly for bi-directional communications (i.e., beyond the passive reception of television programming).

A relatively new technology that has been proposed for data communications is the optical wireless network. According to this approach, data is transmitted by way of modulation of a light beam, in much the same manner as in the case of fiber optic telephone communications. A photoreceiver receives the modulated light, and demodulates the signal to retrieve the data. As opposed to fiber optic-based optical communications, however, this approach does not use a physical wire for transmission of the light signal. In the case of directed optical communications, a line-of-sight relationship between the transmitter and the receiver permits a modulated light beam, such as that produced by a laser, to travel without the waveguide of the fiber optic.

It is contemplated that the optical wireless network according to this approach will provide numerous important advantages. First, high frequency light can provide high bandwidth, for example ranging from on the order of 100Mbps to several Gbps, using conventional technology. This high bandwidth need not be shared among users, when carried out over line-of-sight optical communications between transmitters and receivers. Without the other users on the link, of course, the bandwidth is not limited by interference from other users, as in the case of wireless telephony. Modulation can also be quite simple, as compared with multiple-user communications that require time or code multiplexing of multiple communications. Bi-directional communication can also be readily carried out according to this technology. Finally, optical frequencies are not currently regulated, and as such no licensing is required for the deployment of extra-premises networks.

These attributes of optical wireless networks make this technology attractive both for local networks within a building, and also for external networks. Indeed, it is contemplated that optical wireless communications may be useful in data communication within a room, such as for communicating video signals from a computer to a display device, such as a video projector.

It will be apparent to those skilled in the art having reference to this specification that the ability to correctly aim the transmitted light beam to the receiver is of importance in this technology. Particularly for laser-generated beams, which have quite small spot sizes, the reliability and signal-to-noise ratio of the transmitted signal are degraded if the aim of the transmitting beam strays from the optimum point at the receiver. Especially considering that many contemplated applications of this technology are in connection with equipment that will not be precisely located, or that may move over time, the need exists to precisely aim and controllably adjust the aim of the light beam.

Copending United States patent application S.N. 09/310,284, filed May 12, 1999, and entitled "Optical Switching Apparatus", discloses a micromirror assembly for directing a light beam in an optical switching apparatus. As disclosed in this application, the micromirror reflects the light beam in a manner that may be precisely controlled by electrical signals. As disclosed in this patent application, the micromirror assembly includes a silicon mirror capable of rotating in two axes. The silicon mirror is formed integrally with gimbals, hinges, and a mounting frame. The silicon mirrors are formed by conventional photolithographic processing of a silicon wafer, with the individual integrated mirror structures arranged in an array on the wafer, analogously to integrated circuits.

After dicing of the mirror structures, including their respective gimbals, hinges, and frame, the mirrors are assembled into a package. One ore more small magnets are attached to the micromirror itself; a set of four coil drivers are arranged in quadrants, and are current-controlled to attract or repel the micromirror magnets as desired, to tilt the micromirror in the desired direction.

### BRIEF SUMMARY OF THE INVENTION

The present invention provides a silicon micromirror that can be fabricated with reduced wafer area per wafer structure. The present invention further provides such a micromirror that also provides a larger mirror surface.

The present invention may be implemented by fabricating a stacked silicon micromirror. A lower portion of the micromirror is formed on a silicon wafer, and includes the mounting frame, intermediate gimbals, and a central mounting element. A magnet standoff is mounted to the central mounting element of the lower portion of the micromirror, and a larger silicon mirror is then mounted to the standoff. The resulting stacked micromirror is then preferably packaged into a body with multiple driver coils that, when appropriately energized, cause the mirror to rotate into a desired orientation.

### BRIEF DESCRIPTION OF THE SEVERAL VIEWS OF THE DRAWING

For a more complete understanding of the present invention, and the advantages thereof, reference is now made to the following detailed description of certain particular and illustrative embodiments and the features and aspects thereof, by way of example only, and with reference to the figures of the accompanying drawings in which:
Figure 1 is a schematic drawing of an optical wireless network using the packaged micromirror assembly.
Figure 2 is a plan view of a micromirror formed integrally with its gimbals, hinges, and mounting frame.
Figures 3a and 3b are plan and cross-sectional views, respectively, of a stacked micromirror.
Figure 4 is a plan view of a silicon wafer comparing the density of the integrated micromirror of Figure 2 with the bottom mounting structures of a preferred embodiment of the invention.
Figure 5 is a cross-sectional view of a packaged micromirror assembly.

### DETAILED DESCRIPTION OF THE INVENTION

The present invention will be described in connection with certain preferred embodiments, with an example of an application of these preferred embodiments in a communications network. It is contemplated, however, that the present invention may be realized not only in the manner described below, but also by way of various alternatives which will be apparent to those skilled in the art having reference to this specification. It is further contemplated that the present invention may be advantageously implemented and used in connection with a variety of applications besides those described below. It is therefore to be understood that the following description is presented by way of example only, and that this description is not to be construed to limit the true scope of the present invention as hereinafter claimed.

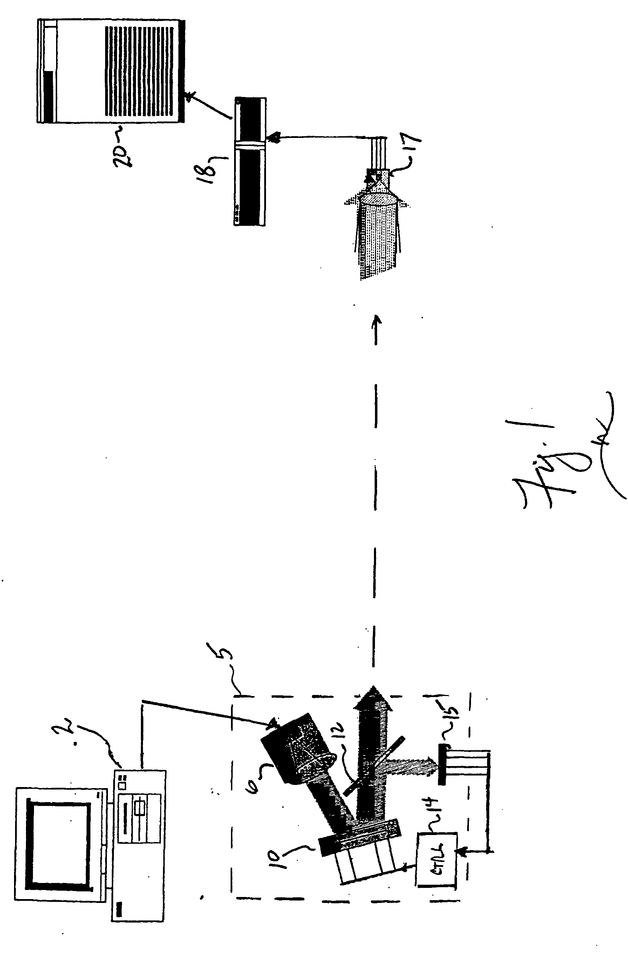

Referring first to Figure 1, an example of an optical wireless network will be illustrated, to provide context for the present invention. In this simple example, unidirectional communications are to be carried out from computer 2 to server 20, by way of modulated directed light. In this example, computer 2 is a conventional microprocessor based personal computer or workstation, including the appropriate network interface adapter for outputting the data to be communicated. Computer 2 is connected to transmitter optical module 5, which aims a directed light beam at the desired receiver 17, and which modulates the light beam to communicate the data.

In this example, transmitter optical module 5 includes modulating laser 6, which generates a collimated coherent light beam of the desired wavelength (e.g., 850 nm) and power (e.g., on the order of 4/5 µW/cm² measured at 50 meters, with a spot size of on the order of 2.0 to 2.5 mm in diameter). Modulating laser 6 modulates this light beam according to the digital data being transmitted. The modulation scheme used preferably follows a conventional data communications standard, such as those used in connection with fiber optic communications for similar networks. The modulated laser beam exits modulating laser 6 and is reflected from micromirror assembly 10 toward receiver 17. The construction of micromirror assembly 10 according to the preferred embodiments of the invention will be described in further detail below.

The reflected laser beam impinges beam splitter 12, in this example. Beam splitter 12 transmits the majority of the energy to receiver 17, but reflects a portion of the energy to position sensitive detector (PSD) 15. PSD 15 provides signals to control circuitry 14, indicating the position of the reflected light that it receives. Control circuitry 14 then issues control signals to micromirror assembly 10 to direct its angle of reflection in response to the signals from PSD 15, to optimize the aim of the directed laser beam at receiver 17. In one example, during setup of the transmission, micromirror assembly 10 and PSD 15 "sweeps" the aim of the directed laser beam across the general area of receiver 17. In response, receiver 17 issue signals to control circuitry 14 over a secondary communications channel (not shown), indicating the received energy over time. These "pings" may be compared with the instantaneous position of micromirror assembly 10 as measured by PSD 15, to calibrate and optimize the aim of micromirror assembly 10 to achieve maximum energy transmission. Once this aim is set, communications may then be carried out. It is contemplated, however, that adjustments may be necessary due to external factors such as building or equipment movement and the like. These adjustments may be carried out by way of feedback from receiver 17 (either over the secondary channel or as transmit mode feedback in a duplex arrangement), or by periodically repeating the measurement and sweeping.

On the receiver end, receiver 17 captures the incoming directed light beam, and converts the modulated light energy to an electrical signal; for example, receiver 17 may include a photodiode, which modulates an electrical signal in response to the intensity of detected light. Such other conventional receiver circuitry, such as demodulators, filters, and the line, are also provided. The demodulated communicated electrical signal is then forwarded from receiver 17 to router 18, and thus into the receiving network, for eventual distribution to server 20, in this example.

As evident from Figure 1 and the foregoing description, this example illustrates a unidirectional, or simplex, communications approach, for ease of this description. It will be appreciated by those skilled in the art that bi-directional, or duplex, communications may be carried out by providing another transmitter-receiver pair for communicating signals in the opposite direction (router 18 to computer 2).

The communications arrangement of Figure 1 may be utilized in connection with a wide range of applications, beyond the simple computer-to-network example suggested by Figure 1. For example, it is contemplated that each of multiple computers in an office or other workspace may communicate with one another and with a larger network by way of modulated light to a central receiver within the room, and also between rooms by way of relayed communications along hallways or in a space frame. Other indoor applications for this optical wireless communications may include the communication of video signals from a computer or DVD player to a large-screen projector. It is further contemplated that optical wireless communications in this fashion may be carried out in this manner but on a larger scale, for example between or among buildings.

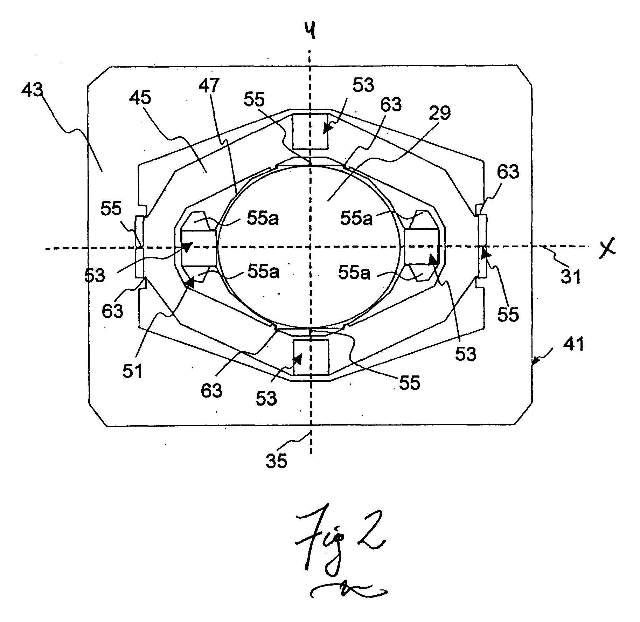

An example of the construction of packaged micromirror assembly 10 is described in copending U.S. patent application S.N. 09/310,284, filed May 12, 1999, entitled "Optical Switching Apparatus". Referring now to Figure 2, the construction of mirror element 41 is described in U.S. patent application S.N. 09/310,284, and as may be packaged as described therein to operate as packaged micromirror assembly 10 of Figure 1, will now be described.

As shown in Figure 2, mirror element 41 is formed of a single piece of material, preferably single-crystal silicon, photolithographically etched in the desired pattern, to form mirror surface 29 and its supporting hinges and frame. To improve the reflectivity of mirror surface 29, mirror element 41 is preferably plated with a metal, such as gold or aluminum. Mirror element 41 also includes a frame portion, an intermediate gimbals portion, and an inner mirror portion, all preferably formed from one piece of crystal material such as silicon. In its fabrication, silicon is etched to provide outer frame portion 43 forming an opening in which intermediate annular gimbals portion 45 is attached at opposing hinge locations 55 along x-axis 31. Inner, centrally disposed mirror portion 47, having a mirror 29 centrally located thereon, is attached to gimbals portion 45 at hinge portions 55 on y-axis 35, which of course is perpendicular to the x-axis. Mirror 29, which is on the order of 100 microns in thickness, is suitably polished on its upper surface to provide a specular surface. Preferably, this polished surface is plated with a metal, such as aluminum or gold, to provide further reflectivity. In order to provide necessary flatness, the mirror is formed with a radius of curvature greater than approximately 2 meters, with increasing optical path lengths requiring increasing radius of curvature. The radius of curvature can be controlled by known stress control techniques such as, by polishing on both opposite faces and deposition techniques for stress controlled thin films. If desired, a coating of suitable material can be placed on the mirror portion to enhance its reflectivity for specific radiation wavelengths.

Mirror element 41 includes a first pair of permanent magnet locations 53 at gimbals portion 45 along the y-axis, and a second pair of permanent magnet locations 53 at extensions 51, which extend outwardly from mirror portion 47 along the x-axis. In order to symmetrically distribute mass about the two axes of rotation to thereby minimize oscillation under shock and vibration, each permanent magnet location preferably receives an upper magnet mounted on the top surface of the mirror element 41 using conventional attachment techniques such as indium bonding, and an aligned lower magnet similarly attached to the lower surface of the mirror assembly. These magnets of each set are arranged serially such as the north/south pole arrangement. There are several possible arrangements of the four sets of magnets which may be used, such as all like poles up, or two sets of like poles up, two sets of like poles down; or three sets of like poles up, one set of like pole down, depending upon magnetic characteristics desired.

By mounting gimbals portion 45 to frame portion 43 by means of hinges 55, motion of the gimbals portion 45 about the x-axis 31 is provided and by mounting mirror portion 47 to gimbals portion 45 via hinges 55, motion of the mirror portion relative to the gimbals portion is obtained about the y-axis 35, thereby allowing independent, selected movement of the mirror portion 47 along two orthogonal axes.

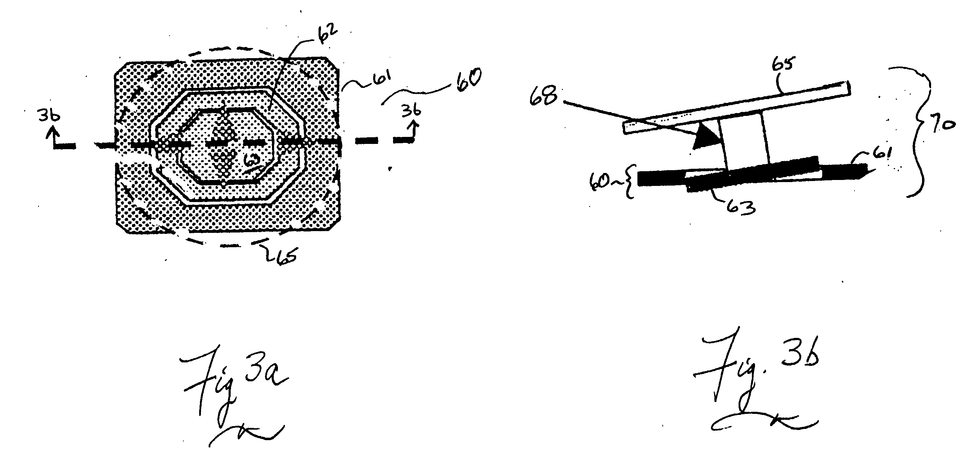

Referring now to Figures 3a and 3b, the construction of micromirror 70 according to the preferred embodiment of the invention will now be described in detail. As shown in Figure 3a, micromirror 70 includes a lower element 60 that includes mounting frame 61, intermediate gimbals portion 62, and center mounting element 63. Hinges for allowing two-axis rotation of center mounting element 63 are provided as described above relative to Figure 2 (but are not shown for clarity). As such, this lower element 60 is constructed substantially similarly as mirror element 41 of Figure 2, integrally from a single piece of silicon, except that center mounting element 63 does not serve as the reflecting mirror. Rather, as shown in Figure 3b, upper mirror 65 overlies lower element 60, and is attached to lower element 60 by way of magnet standoff 68. Upper mirror 65 is also preferably formed of a single piece of material, preferably single-crystal silicon; multiple upper mirrors 65 may be formed from the same wafer, diced into the appropriate size and shape.

Magnet standoff 68 is preferably a permanent magnet, formed of any permanently magnetizable material, a preferred example of which is neodymium-iron-boron. The length of magnet standoff 68 should be selected to provide the appropriate deflection of upper mirror 65, and the moment that may be reliably supported by the hinges of lower element 60. Magnet standoff 68 is preferably attached to lower element 60 and upper mirror 65 by conventional attachment techniques such as indium bonding. Magnet standoff 68 should be mounted coaxially with the center of upper mirror 65 to provide a balanced mass.

According to this embodiment of the invention, the single magnet provided by magnet standoff 68 is rotatable under the control of an external magnetic field applied to micromirror 70. As will be described in further detail below, micromirror 70 is packaged together with such external magnets, in the form of coil drivers, which are capable of orienting magnet standoff 68, and thus upper mirror 65, in the desired direction.

Alternatively to magnet standoff 68 being itself a permanent magnet, a non-magnetic standoff may be used in place of magnet standoff 68 between upper mirror 65 and lower element 60. According to this alternative, a magnet may be attached to the underside of center mounting element 63, coaxially aligned with the standoff. Further in the alternative, multiple magnets may be attached to lower element 60 at locations similarly as described above relative to Figure 2, in combination with a non-magnetic standoff.

In Figure 3a, the location of upper mirror 65 is shown by way of the broken line. As evident from Figures 3a and 3b, upper mirror 65 may be significantly larger than center mounting element 63. This permits upper mirror 65 to be formed as large as appropriate for the desired reflecting performance, while center mounting element 63 need only be large enough to accommodate magnet standoff 68. This permits lower element 60 to be much smaller, for a given size of mirror 65, than according to the construction of Figure 2. As illustrated in Figure 3a, the wafer area efficiency of lower element 60, measured as the size of mirror 65 relative to the size of lower element 60, is on the order of 100% according to this embodiment of the invention. This improvement is because the mounting frame, gimbals, and mirror need not be formed from the same planar silicon element, as in the case of mirror element 41 of Figure 2.

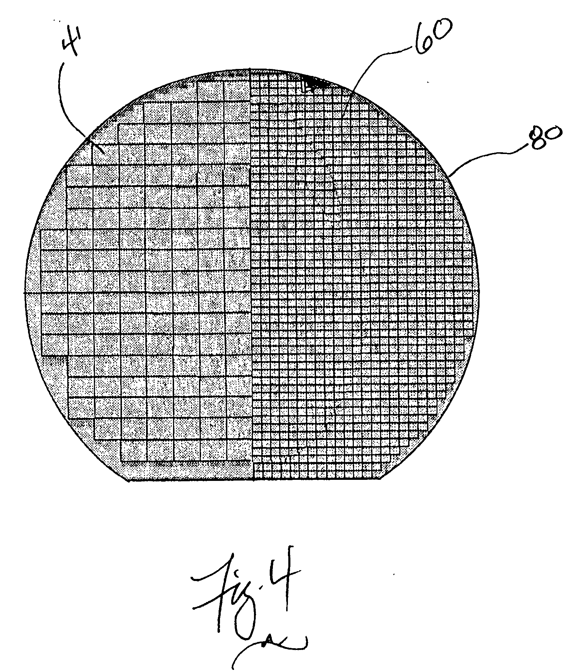

Figure 4 illustrates an example of the relative densities of mirror element 41 and lower element 60, as if both elements were formed on the same wafer 80. As evident from Figure 4, many more lower elements 60 may be formed in the same wafer area than mirror elements 41. For example, it is contemplated that six times as many lower elements 60 as mirror elements 41 may be formed in the same area. This results in a significant reduction of manufacturing cost according to the preferred embodiment of the invention, despite the requirement of separately forming upper mirrors 65 in another wafer. This is because the cost of the intricate and expensive processing required to form hinges and gimbals in lower elements 60 is spread among many more micromirrors according to the preferred embodiment of the invention; the less precise plating and dicing of upper mirrors 65 is relatively inexpensive.

Additionally, since lower elements 60 do not actively reflect the laser beam in the network application, lower elements 60 need not be plated with a reflective metal such as gold or aluminum, providing additional relief in the manufacturing cost.

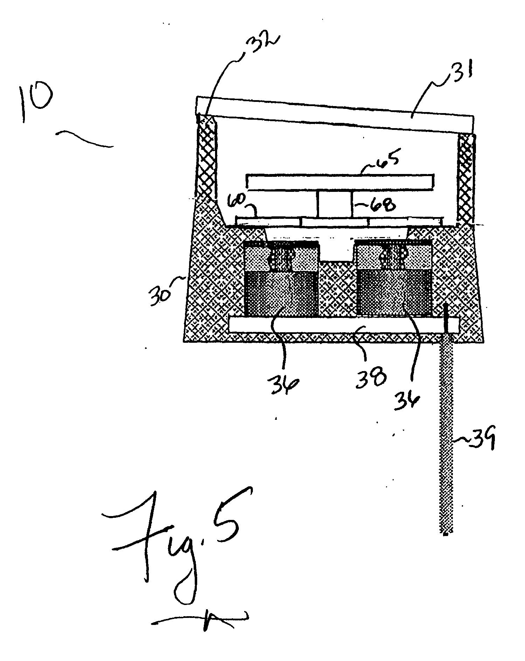

Figure 5 illustrates an example of packaged micromirror 10 including micromirror 70 according to the preferred embodiment of the invention. It is contemplated that the present invention may be embodied in many types of packages, including hermetically sealed packages as described in copending U.S. patent application S.N. 09/310,284. Figure 5 illustrates the example of molded packaged micromirror 10.

Lower element 60, in this embodiment of the invention, rests upon and is attached to shelf 34 of body 30. Body 30, according to this first preferred embodiment of the invention, is formed of a plastic material cast around coil drivers 36 and driver circuit board 38. This plastic material both facilitates the manufacture of micromirror assembly 10, and also provides a high reliability package for structural and environmental protection of the precision components in assembly 10. A preferred material for body 30 in this embodiment of the invention is a filled two-part epoxy, such as T905 or T7110 epoxy, available from Epoxy Technology. Alternatively, a cured rubber or a soft plastic may be used as the material of body 30.

Shelf 34 lies inwardly of window shelf 32, upon which transparent window 31 rests and is attached. Window 31 may be formed of conventional microscope slide glass, or of a transparent plastic such as LEXAN plastic. It is preferred that the maximum deflection of mirror 65 is limited to an angle that is well below that which overstresses hinges 55.

Disposed within body 30 are coil drivers 36, which are externally wound electromagnets about a corresponding bobbin. Because of the cross-sectional view of Figure 5, only two coil drivers 36 are illustrated; however, two more coil drivers 36 are similarly provided within micromirror assembly 10. The bobbin of each coil driver 36 is preferably made of suitable material for the desired properties of heat transfer, magnetic dampening, and strength, for example liquid clear polymer or aluminum. Each bobbin is wound with highly conductivity wire such as copper. Coil drivers 36 are each electrically connected to driver circuit board 38 by way of wires (not shown in Figure 5), which in turn has external pins 39 (only one of which is visible in Figure 5) to provide external electrical connection to coil drivers 39. Pins 39 may be conventional integrated circuit package pins as shown, for mounting through holes in a circuit board; alternatively, pins 39 may be of the surface mount type.

In operation, electrical signals communicated via pins 39 are applied to coil drivers 36, to control each coil driver 36 to generate a magnetic field of the desired polarity and magnitude. The magnetic field generated by each coil driver 36 either attracts or repels magnet standoff 68, causing a net torque on upper mirror 65. Proper control of the current applied to the set of coil drivers 36 orients upper mirror 65 in the desired direction, with a high degree of precision.

In this regard, it is contemplated that the control of the orientation of upper mirror 65 be made by way of a feedback control system. Figure 1 illustrates the example of a beam-splitter and PSD feedback control arrangement. Alternatively, it is contemplated that in-package sensing may be included within a packaged micromirror assembly.

The present invention provides important advantages in the fabrication and use of micromirrors, such as in communications networks. In particular, the present invention permits a much reduced manufacturing cost of the micromirror assemblies, as well as enabling the independent optimization of mirror surface area and wafer area for the gimbal and hinge assemblies.

While the present invention has been described according to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. A micromirror assembly, comprising:
a package body;
a lower mirror element formed of a single piece of crystalline material, the lower mirror element comprising:
a central mounting element;
a frame portion surrounding the central mounting element, coupled to the central mounting element by a plurality of hinges, and mounted to the package body;
a standoff attached on one end to the central mounting element;
an upper mirror attached to another end of the standoff; and
a plurality of coil drivers for orienting the upper mirror by generating a controlled magnetic field.

2. The assembly of claim 1 wherein the standoff comprises:
a permanent magnet, for orienting the upper mirror in response to the magnetic field.

3. The assembly of claim 1 or claim 2 further comprising:
at least one permanent magnet attached to the lower mirror element, for orienting the upper mirror in response to the magnetic field.

4. The assembly of any preceding claim, wherein the lower mirror element further comprises:
an intermediate gimbal portion surrounding the central mounting element and surrounded by the frame portion, the intermediate gimbal portion coupled to the central mounting element and the frame portion by the plurality of hinges.

5. The assembly of any preceding claim, wherein the area of the upper mirror is substantially the same as the area of the lower mirror element.

6. The assembly of any preceding claim, wherein the upper mirror has a reflecting surface plated with a reflective metal.

7. A micromirror, comprising:
a lower mirror element formed of a single piece of crystalline material, the lower mirror element comprising:
a central mounting element;
a frame portion surrounding the central mounting element, coupled to the central mounting element by a plurality of hinges;
a standoff attached on one end to the central mounting element; and
an upper mirror attached to another end of the standoff.

8. The micromirror of claim 7, wherein the standoff comprises a permanent magnet.

9. The micromirror of claim 7 or claim 8 further comprising:
at least one permanent magnet attached to the lower mirror element.

10. The micromirror of any of claims 7 to 9, wherein the lower mirror element further comprises:
an intermediate gimbal portion surrounding the central mounting element and surrounded by the frame portion, the intermediate gimbal portion coupled to the central mounting element and the frame portion by the plurality of hinges.

11. A method of fabricating a micromirror, comprising:
forming an integrated lower mirror element from a single piece of silicon, the integrated lower mirror element having a central mounting element surrounded by an intermediate gimbal portion, which in turn is surrounded by a frame portion, the central mounting element, intermediate gimbal portion and frame portion coupled to one another by a plurality of hinges;
attaching one end of a standoff to the central mounting element;
forming an upper mirror element;
attaching the upper mirror element to another end of the standoff.

12. The method of claim 11, wherein the step of forming the upper mirror element comprises:
plating a silicon wafer to form a reflective surface;
dicing the plated silicon wafer to form the upper mirror element.

13. The method of claim 11 or claim 12, further comprising:
attaching a permanent magnet to the lower mirror element.

14. The method of any of claims 11 to 13, wherein the standoff comprises a permanent magnet.
